# EUROPÄISCHE PATENTSCHRIFT

(11) **EP 3 260 025 B1**
(45) Veröffentlichungstag und Bekanntmachung des Hinweises auf die Patenterteilung: **01.01.2020**
(21) Anmeldenummer: 17177313.8
(22) Anmeldetag: 22.06.2017
(51) Int. Cl.: A47J 31/44

(54) **VERFAHREN UND VORRICHTUNG ZUM ERZEUGEN VON MILCH-LUFT-EMULSIONEN**
DEVICE AND METHOD FOR CREATING MILK/AIR EMULSIONS
PROCÉDÉ ET PROCÉDÉ DE FABRICATION D'ÉMULSIONS LAIT/AIR

(30) Priorität: 22.06.2016 DE 102016111423
(43) Veröffentlichungstag der Anmeldung: 27.12.2017
(73) Patentinhaber: Melitta Professional Coffee Solutions GmbH & Co. KG, 32429 Minden (DE)
(72) Erfinder: DIESTER, Thomas, 31675 Bückeburg (DE); BUCHHOLZ, Bernd, 32369 Rahden (DE)
(74) Vertreter: Specht, Peter

(56) Entgegenhaltungen:
- EP-A1- 3 181 021
- EP-A2- 2 036 472
- CH-A2- 705 720

## Beschreibung

Die Erfindung betrifft ein Verfahren und eine Vorrichtung zum Erzeugen von Milch-Luft-Emulsionen, vorzugsweise von Milchschäumen.

Bei der Herstellung von milchhaltigen Getränken mit Milchschäumen können unterschiedliche Qualitäten von Milchschäumen den Geschmack des Getränks und die optische Erscheinung des Getränks deutlich beeinflussen. Hierzu wurden seitens der Anmelderin bereits einige Verbesserungen an einer Vorrichtung zur Herstellung von Milchschäumen vorgenommen.

Die DE 10 2014 105 108 A1 offenbart z.B. einen Homogenisator, welcher eine Optimierung des Milchschaumes aufgrund von Prallkörpern vornimmt, auf welche der Milchschaum trifft.

Die DE 10 2014 112 178 A1 offenbart ein Luftzuführsystem mit einer Ansaugvorrichtung für Luft und eine Drossel zur gezielten Abgabe von Luft in Milch mit dem Ziel einer automatisierten Aufschäumung dieser Milch.

Einen gattungsgemäßen Stand der Technik offenbart die CH 705 720 A2, in welcher vorgeschlagen wird, Milchschaum - also eine Milch-Luft-Emulsion - in Abhängigkeit von der ermittelten Produkttemperatur zu erzeugen.

Zum gattungsgemäßen Stand der Technik sei auf die nachveröffentlichte EP 3 181 021 A1 hingewiesen.

Die Erfindung hat die Aufgabe, ein Verfahren zum Erzeugen von Milch-Luft-Emulsionen bereitzustellen, welches eine vorzugsweise kontinuierliche Überwachung und Korrektur der Qualität und Beschaffenheit der Milch-Luft-Emulsionen ermöglicht.

Die Erfindung löst diese Aufgabe durch ein Verfahren mit den Merkmalen des Anspruchs 1 und durch eine Vorrichtung mit den Merkmalen des Anspruchs 11.

Ein erfindungsgemäßes Verfahren zur Herstellung von Milch-Luft-Emulsionen, insbesondere von Milchschäumen, wird mit einer Vorrichtung zum Erzeugen von solchen Milch-Luft-Emulsion realisiert. Dabei erfolgt eine Regelung des Verfahrens in Abhängigkeit von zumindest einer ermittelten physikalischen Stoffeigenschaft nach den im Anspruch 1 angegebenen Schritten und mit den dort angegebenen Merkmalen. Derart kann einfach, sicher und gut die Beschaffenheit der Milch-Luft-Emulsion entsprechend gewünschter Vorgaben überwacht, eingestellt und angepasst werden.

Vorteilhafte Ausführungsformen sind in den abhängigen Ansprüchen genannt. Das Verfahren kann vorteilhaft bei der Herstellung eines milchschaumhaltigen Getränkes, so eines Kaffeegetränks angewandt werden. Es sind sowohl Heiß- als auch Kaltgetränke mit Milchschaum im Rahmen des erfindungsgemäßen Verfahrens realisierbar.

Die vorgenannte Vorrichtung weist erfindungsgemäß die im Anspruch 11 genannten Bauteile bzw. Elemente a) bis f) auf.

### Dazu ist folgendes anzumerken:

Die Milchleitung des Merkmals a) kann sich von einem Milchvorratsbehälter, einem Milchkühlschrank oder dergleichen bis hin zu einer Ausgabeeinheit, an welcher der Milchschaum in oder auf das Getränk in ein Gefäß abgegeben wird, erstrecken.

Das Luftzuführsystem des Merkmals b) kann auf Basis einer Ansaugvorrichtung arbeiten oder aber es kann eine Druckluftleitung, z.B. einer Luftflasche, angeschlossen sein. Der Begriff "Luft" ist dabei nicht nur auf die konkrete Zusammensetzung von Umgebungsluft begrenzt. Es kann sich bei der Luft um jedes lebensmitteltechnisch-unbedenkliches Gas handeln, so z.B. auch reiner Stickstoff oder Sauerstoff.

Die wenigstens eine Verarbeitungseinrichtung c) dient zum Weiterverarbeiten der Milch-Luft-Emulsion, insbesondere mit wenigstens einer Erwärmungseinrichtung zum Erwärmen/Erhitzen der Milch-Luft-Emulsion. Dabei kann die Milch oder die Milch-Luft-Emulsion eine erste Temperatur T1 aufweisen und auf eine warme Temperatur T2 und/oder einer heiße Temperatur T3, wobei T3 > T2 > T1, aufgeheizt werden.

Die Verarbeitungseinrichtung des Merkmals c) kann ausgelegt sein zur direkten oder indirekten Erwärmung. Es ist bevorzugt, wenn eine direkte Erwärmung durch Einleitung eines gasförmigen lebensmittelverträglichen Heizmediums, insbesondere von Dampf, vorgesehen ist, um den Milchschaum auf die heiße Temperatur T3 zu erhitzen und wenn eine indirekte Erwärmung, z.B. durch Wärmetausch mit einem Heizmedium oder durch ein elektrisches Heizelement, z.B. einen Heizdraht oder dergleichen, vorgesehen ist um den Milchschaum auf eine warme Temperatur T2 < T3 zu erhitzen. Die Temperatur T3 des heißen Milchschaumes beträgt bevorzugt zwischen 55° C und 80°C und die Temperatur T2 des warmen Milchschaumes ist eine denaturierend wirkende Temperatur, insbesondere eine Temperatur T2 zwischen 40° C und 54°C.

Die erste Messeinheit des Merkmals d) kann eine oder mehrere Sensoren aufweisen. Die Messeinheit kann Messwerte, z.B. in Form von einer Spannung messen, aus welchen eine physikalische Stoffeigenschaft ermittelbar ist. Das erfindungsgemäße Verfahren umfasst zudem, dass eine Ermittlung zumindest einer physikalischen Stoffeigenschaft der Milch-Luft-Emulsion erfolgt durch zumindest eine erste Messeinheit erfolgt.

Die Regel- und Auswerteeinheit des Merkmals e) ist ausgelegt bzw. ausgerüstet zur Einstellung einer Steuergröße anhand der physikalischen Stoffeigenschaft der Milch-Luft-Emulsion, wobei die Regel- und Auswerteeinheit einen Datenspeicher aufweist, auf welchem Datensätze von Sollwerten und/oder Sollwertbereichen in Abhängigkeit von der Temperatur und/oder einem gewünschten milchhaltigen Getränk und/oder einer zugeführten Milchsorte hinterlegt sind.

Derart können für Getränke verschiedenster Art jeweils optimal ausgelegte Milch-Luft-Emulsionen erzeugt werden.

Das erfindungsgemäße Verfahren, mit dem Milch-Luft-Emulsionen, insbesondere Milchschäume, mit einer Vorrichtung zum Erzeugen eines Milchschaums nach Art des Anspruchs 11 hergestellt werden, umfasst zumindest folgende Schritte:
A) Ermitteln der wenigstens einen physikalischen Stoffeigenschaft der Milch-Luft-Emulsion durch zumindest die erste Messeinheit;
B) mit der Regel- und Auswerteeinheit ein Vergleich zwischen einem Ist-Wert und einem Sollwertbereich dieser physikalischen Stoffeigenschaft erfolgt,
C) wobei, sofern der Istwert außerhalb des Sollwertbereiches liegt, mit der Regel- und Auswerteeinheit ein Einstellen zumindest einer Stellgröße im Verfahren erfolgt, derart, dass die physikalische Stoffeigenschaft beeinflusst wird,
D) Dabei bestimmt die Regel- und Auswerteeinheit während eines Bezuges - aufbauend auf den hinterlegten Datensätzen - ein nicht konstantes und während des Bezuges veränderbares bzw. sich veränderndes Profil von Sollwerten und/oder Sollwertbereichen und nimmt danach die Regelung vor.

Das erfindungsgemäße Verfahren umfasst insofern, dass ein Vergleich zwischen einem Ist-Wert und einem Sollwert bzw. Sollwertbereich dieser physikalischen Stoffeigenschaft erfolgt und dass, sofern der Istwert außerhalb des Sollwertbereiches liegt, ein Einstellen zumindest einer Stellgröße im Verfahren erfolgt, derart, dass die physikalische Stoffeigenschaft entsprechend gewünschter Vorgaben bzw. entsprechend des Sollwertbereichs beeinflusst wird.

Das Vergleichen und das Einstellen können werden durch die Regel- und Auswerteeinheit der vorstehend beschriebenen Art vorgenommen.

Die wenigstens eine physikalische Stoffeigenschaft kann besonders vorteilhaft die elektrische Leitfähigkeit der Milch-Luft-Emulsion sein. Diese Stoffeigenschaft lässt sich mit Leitfähigkeitssensoren mit vergleichsweise geringen Schwankungstoleranzen ermitteln. Derart kann nach der Erkenntnis der Erfindung besonders gut die Beschaffenheit der Emulsion ermittelt und beurteilt werden. Es handelt sich um eine einerseits gute messbare und andererseits auch gut beeinflussbare Stoffeigenschaft.

Anhand der ermittelten wenigstens einen oder mehreren physikalischen Stoffeigenschaft(en) kann ein Einstellen der Stellgröße durch Regelung des Luftdruckes der durch das Luftzuführsystem zugeführten Luft erfolgen. Bei einem Luftansaugsystem, welches im Rahmen der vorliegenden Erfindung ebenfalls als Luftzuführsystem zu verstehen ist, kann dies auch eine Regelung eines Unterdruckes der Luft bedeuten.

Alternativ oder zusätzlich kann das Einstellen der Stellgröße auch vorteilhaft eine Regelung des Durchflusses der Milch oder der Milch-Luft-Emulsion durch die Milchleitung umfassen. Dies kann vorzugsweise durch eine Regelung des Durchflusses der Milch oder der Milch-Luft-Emulsion durch eine Mischkammer, in welcher die Milch-Luft-Emulsion gebildet wird, geschehen. Die Durchflussregelung kann auch einen Nulldurchfluss über ein Zeitintervall umfassen, d.h. die Verweilzeit der Milch in der Mischkammer kann geregelt werden. Je länger die Milch in der Mischkammer verweilt, desto stärker wird sie, auch bei konstantem Luftdruck, aufgeschäumt.

Das Einstellen der Stellgröße kann zudem vorteilhaft oder alternativ eine Regelung des Durchflusses des Heizmediums, insbesondere von Heißdampf, oder der Leistung einer elektrischen Heiz- bzw. Erwärmungseinheit in der Verarbeitungseinrichtung umfassen. Dadurch kann anhand der ermittelten physikalischen Stoffeigenschaft auch die Temperatur der Milch-Luft-Emulsion eingestellt werden.

Das Verfahren kann zudem vorteilhaft die folgenden Schritte umfassen:
- Fördern von Milch in der Milchleitung beispielsweise mittels einer Milchpumpe.

Eine solche Milchpumpe kann beliebig ausgebildet sein, so z.B. als Ansaugpumpe.
- Mischen von Milch und Luft durch Einleiten (auch Ansaugen) von Luft vom Luftzuführsystem in die Milch.

Das Mischen von Milch und Luft kann bevorzugt in einer Mischkammer des Luftzuführsystems erfolgen. Es kann sowohl eine kalte oder eine vorgewärmte Milch auf diese Weise aufgeschäumt werden.

Ggf. kann sodann ein Erwärmen der Milch- Luft-Emulsion erfolgen. Vorteilhafterweise kann die Erwärmung auf eine Temperatur T2 oder T3 von mehr als 40°C erfolgen.

Zwar ist in der erfindungsgemäßen Vorrichtung stets eine Verarbeitungseinrichtung mit einer Heizeinheit vorgesehen, diese Heizeinheit muss allerdings nicht bei allen Milchschäumen zugeschalten werden, sondern die Milch- oder der Milchschaum kann auch ohne Erwärmung durch die Verarbeitungseinrichtung geleitet werden, so dass auch kalter Milchschaum ausgegeben werden kann. Die Begriffe Heizeinheit und Erwärmungseinheit werden im Rahmen der vorliegenden Erfindung synonym verwendet.

Somit kann das Erwärmen durch das Heizmedium optional erfolgen. Es muss nicht zwingend ein Erwärmen erfolgen, sondern es kann auch der kalte Milchschaum direkt ausgegeben werden. Allerdings kann die Verarbeitungseinrichtung eingesetzt werden um Milchschaum zu erwärmen oder zu erhitzen.

Sodann erfolgt vorzugsweise eine Ermittlung der physikalischen Stoffeigenschaft durch die erste Messeinheit und die Regel- und Auswerteeinheit. Die Ermittlung kann eine direkte Messung der Stoffeigenschaft umfassen oder eine Messung von Messdaten, welche sodann durch die Regel- und Auswerteeinheit in einen repräsentativen Wert für die entsprechende Stoffeigenschaft berechnet wird.

Somit kommt es zu einer geregelten Anpassung der Temperatur des Milchschaumes in der Verarbeitungseinrichtung und/oder zu einem geregelten Aufschäumen der Milch in dem Luftzuführsystem. Bei beiden Anpassungen ändert sich bevorzugt die Stoffeigenschaft, z.B. die Leitfähigkeit, da die Stoffeigenschaft vorzugsweise temperaturabhängig ist.

Die Regelung kann vorzugsweise durch Ermittlung eines Istwertes für die Stoffeigenschaft erfolgen. Sodann kann ein Abgleich mit einem hinterlegten Sollwert und/oder Sollwertbereichs für die Stoffeigenschaft durch die Regel- und Auswerteeinheit erfolgen. Über- oder unterschreitet der Istwert den hinterlegten Sollwert und/oder Sollwertbereich, so kommt es zu einer Anpassung einer oder mehrerer Stellgrößen, welche im vorliegenden Fall der Luftdruck, die Durchflussgeschwindigkeit der Milch und/oder die Zufuhr an Wärmeenergie ist. Dies kann durch Steuerung einer oder mehrerer Ventile oder durch Ansteuerung einer oder mehrerer elektrisch wirkender Komponenten erfolgen. Somit kann die Qualität des Milchschaumes hinsichtlich seiner Temperatur und des Verhältnisses Luft zu Milch eingestellt werden. Letzteres Verhältnis wird durch die Ermittlung einer physikalischen Stoffeigenschaft, so z.B. der Dichte, der Viskosität, der thermischen und/oder besonders bevorzugt der elektrischen Leitfähigkeit bestimmt.

Die Regelung kann bevorzugt eine kontinuierliche Anpassung des Durchflusses der Milch, des Heizmediums und/oder des Luftdruckes in Abhängigkeit von der ermittelten physikalischen Stoffeigenschaft der Milch-Luft-Emulsion im kontinuierlichen Betrieb der erfindungsgemäßen Vorrichtung ermöglichen.

Die erste oder zweite Messeinheit zur Ermittlung der elektrischen Leitfähigkeit kann darüber hinaus zur Erkennung des Fehlens von Milch oder des Fehlens von Reinigungsfluid bei einer automatischen Reinigung der erfindungsgemäßen Vorrichtung eingesetzt werden.

Es können zudem produktindividuelle Sollwerte, je nach Milchschaumtyp und eingesetzter Milch (Fettanteil, Soya-Milch, tierische Milch usw.), auf dem Datenspeicher der Regel- und Auswerteeinheit hinterlegt sein, welche vom Nutzer durch Auswahl der eingesetzten Milchsorte und des ausgewählten Getränks von der Regel- und Auswerteeinheit auswählbar und abrufbar sind.

Es ist von Vorteil, wenn die Vorrichtung die erste Messeinheit und dazu eine zweite Messeinheit aufweist, wobei die Messeinheit zwischen dem Luftzuführsystem zur Erzeugung der Milch- Luft-Emulsion und der Verarbeitungseinrichtung zur Erwärmung der Milch- Luft-Emulsion angeordnet ist und wobei die zweite Messeinheit in Durchflussrichtung R der Milch bzw. Milch- Luft-Emulsion nach der Verarbeitungseinrichtung angeordnet ist, wobei die physikalische Stoffeigenschaft vor und nach der Erwärmung der Milch- Luft-Emulsion bestimmt wird. Die erste und die zweite Messeinheit dienen bevorzugt der Ermittlung der physikalischen Stoffeigenschaft und kommunizieren ebenfalls bevorzugt mit der Regel- und Auswerteeinheit. Es kann sich insbesondere um zwei Leitfähigkeitssensoren zur Bestimmung der elektrischen Leitfähigkeit handeln.

Die Vorrichtung kann zudem einen Temperatursensor aufweisen, welcher in Durchflussrichtung R der Milch bzw. Milch- Luft-Emulsion nach der Verarbeitungseinrichtung angeordnet ist und welcher die Temperatur der Milch-Luft-Emulsion ermittelt und wobei die Regel- und Auswerteeinheit eine Temperaturkompensation der ermittelten physikalischen Stoffeigenschaft vornimmt.
Der Temperatursensor kann vorzugsweise in kompakter Ausgestaltung Bestandteil der zweiten Messeinheit sein und/oder als Baueinheit mit dem Leitfähigkeitssensor ausgebildet sein.

Die Verarbeitungseinrichtung kann zudem zumindest eine Verarbeitungsleitung zur Erwärmung der Milch-Luft-Emulsion aufweist, in welcher das Heizmedium, vorzugsweise eine heiße Flüssigkeit oder ein Dampf, geführt ist, wobei die Verarbeitungsleitung zumindest ein Stellventil zur Regulierung des Durchflusses des Heizmediums in der Verarbeitungsleitung aufweist, wobei das Stellventil in Abhängigkeit von der ermittelten Temperatur des Temperatursensors und/oder in Abhängigkeit von der ermittelten physikalischen Stoffeigenschaft, insbesondere durch die Regel- und Auswerteeinheit geregelt wird.

Die Verweilzeit der Milch-Luft-Emulsion in der Heizeinrichtung kann in Abhängigkeit der ermittelten physikalischen Stoffeigenschaft eingestellt werden. So ist es beispielsweise denkbar, dass Luft mit einem konstanten Luftdruck in die Milch eingeblasen wird, allerdings die Verweilzeit der Milch z.B. in der Mischkammer in Abhängigkeit von der physikalischen Stoffeigenschaft einstellbar ist. Selbstverständlich kann die Verweilzeit der Milch in der Mischkammer des Luftzuführsystems auch zusätzlich zum Luftdruck einstellbar sein.

Eine erfindungsgemäße Vorrichtung zur Erzeugung einer Milch-Luft-Emulsion, insbesondere von Milchschäumen, umfasst eine von Milch durchflossenen Milchleitung, und wenigstens ein Luftzuführsystem zur Erzeugung einer Milch-Luft-Emulsion. Vorgesehen ist ferner eine Verarbeitungseinrichtung zur Erwärmung einer Milch-Luft-Emulsion und zumindest eine erste Messeinheit, zur Ermittlung einer physikalischen Stoffeigenschaft der Milch-Luft-Emulsion, sowie eine Regel- und Auswerteeinheit zur Einstellung einer Steuergröße anhand der physikalischen Stoffeigenschaft der Milch-Luft-Emulsion.

Die Messeinheit kann ein Messaufnehmer eines Messgerätes oder eine Kombination mehrerer Messaufnehmer bzw. Sensoren eines Messgeräts sein. Die Regel- und Auswerteeinheit kann ein Messumformer des Messgerätes sein. Eine physikalische Stoffeigenschaft kann z.B. eine Dichte, eine Viskosität, eine thermische und/oder elektrische Leitfähigkeit sein.

Die Regel- und Auswerteeinheit ist eingerichtet zur Einstellung einer Steuergröße in Abhängigkeit von der ermittelten physikalischen Stoffstoffeigenschaft.

Mit der erfindungsgemäßen Vorrichtung ist es somit möglich, die Luftzufuhr in Abhängigkeit von den Stoffeigenschaften des Milchschaums einzustellen.

Es ist von Vorteil, wenn die Vorrichtung eine Stelleinheit zur Einstellung der Steuergröße aufweist, welche Stelleinheit eine Drossel, vorzugsweise eine einstellbare

Drossel, ist, die Teil des Luftzuführsystems ist und den Luftdruck der durch das Luftzuführsystem zugeführten Luft regelt. Besonders bevorzugt und vorteilhaft kann als einstellbare Drossel ein Nadelventil, vorzugsweise ein automatisch verstellbares Nadelventil, eingesetzt werden.

Zur Ermittlung der physikalischen Stoffeigenschaft kann die Temperatur der Milch-Luft-Emulsion berücksichtigt werden. Dies ist z.B. durch Temperaturermittlung durch einen Temperatursensor erfolgen und eine Temperaturkompensation der ermittelten physikalischen Stoffeigenschaften auf eine Standardtemperatur z.B. bei 25°C. Damit kann der Sollwert besser mit dem Istwert verglichen werden. Alternativ kann auch der Sollwert bei unterschiedlichen Temperaturen hinterlegt sein, so dass bei ermittelter Temperatur der Istwert und der Sollwert der physikalischen Stoffeigenschaft bei der am Ort und zum Zeitpunkt der Messung vorherrschenden Temperatur des Milchschaumes verglichen werden kann.

Das Luftzufuhrsystem kann eine Luftleitung zum Ansaugen von Luft in die Luftleitung des Luftzuführsystems umfassen.

Durch eine Verwendung einer einstellbaren Drossel in dieser Luftleitung als Stelleinheit in Kombination mit der Möglichkeit der Regelung der verschiedenen Erwärmungseinheiten ist die zugeführte Luftmenge in Abhängigkeit einer physikalischen Stoffeigenschaft, insbesondere in Abhängigkeit von der Leitfähigkeit und der Temperatur des hergestellten Milch- Luft- Gemisches einstellbar.

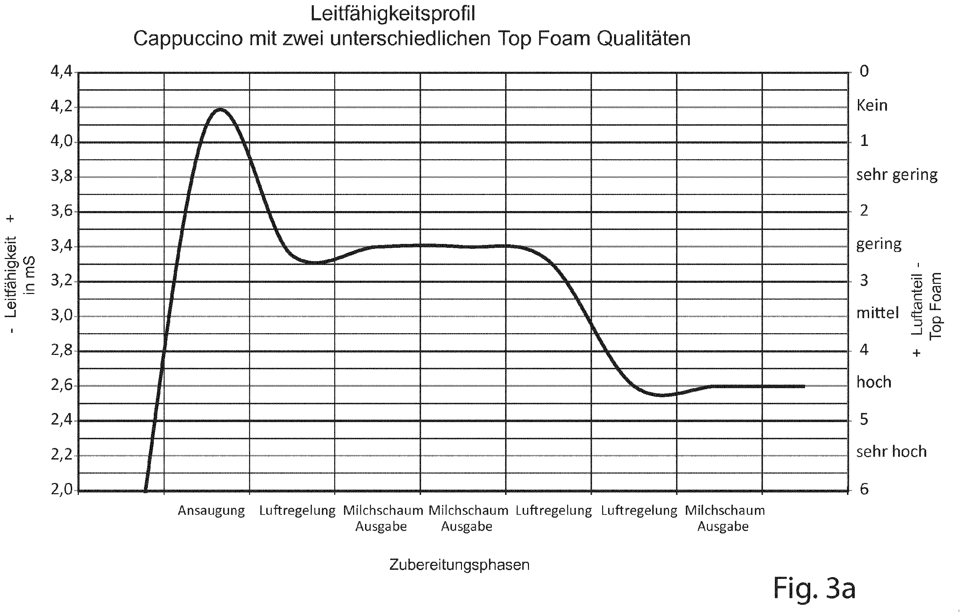

Die Regel- und Auswerteeinheit kann vorteilhaft einen Mikrocontroller und oder mit einem Datenspeicher aufweisen, wobei auf letzterem Datensätze von Sollwerten und/oder Sollwertbereichen in Abhängigkeit von der Temperatur und/oder einem gewünschten milchhaltigen Getränk und/oder einer verwendeten Milchsorte hinterlegt sind. Die Datensätze können beispielsweise als Messwertsätze nach Art z.B. der noch später zu erläuternden Fig. 3a) bis d) aber auch in Form von Funktionen hinterlegt sein.

Erfindungsgemäß ist vorgesehen, dass die Regel- und Auswerteeinheit während eines Bezuges ein nicht konstantes und während des Bezuges veränderbares Profil von Sollwerten und/oder Sollwertbereichen bestimmt und danach die Regelung des Verfahrens vornimmt.

Die Auswerteeinheit kann besonders bevorzugt die Schaumart, sowie den jeweiligen Herstellungsprozess u.a. mit der gewünschten Konsistenz des Endproduktes, der Milchtemperatur, der Milchsorte und/oder den Aufstellbedingungen der Maschine berücksichtigen. Diese Faktoren können im Rahmen einer Justierung und/oder Kalibrierung durch Datensätze hinsichtlich der Sollwertbereiche berücksichtigt werden. Unterschiedliche Milchschaumarten bedingen zudem ebenfalls eine unterschiedliche zugeführte Luftmenge, auf dies ist durch entsprechende Datensätze zu berücksichtigen.

Diese Einstellung, welche z.B. manuell ausgetestet werden mussten, können nunmehr automatisch durch die erfindungsgemäße Vorrichtung durchgeführt werden.

Insgesamt kann eine Selbstjustierung der erfindungsgemäßen Vorrichtung erreicht werden.

Der Durchfluss der Milch und/oder der Milch-Luft-Emulsion kann durch Einstellung der Milchpumpenleistung eingestellt werden.

Die bevorzugt-ermittelte physikalische Stoffeigenschaft ist die elektrische Leitfähigkeit der Milch-Luft-Emulsion. Denn mit dieser kann nach der Erkenntnis der Erfindung besonders gut die Beschaffenheit der Emulsion ermittelt und beurteilt werden. Es handelt sich um eine einerseits gute messbare und andererseits auch gut beeinflussbare Messgröße.

Im Rahmen der vorliegenden Erfindung kann das erfindungsgemäße Verfahren und/oder die erfindungsgemäße Vorrichtung in einem Gerät zur Ausgabe, und insbesondere auch zur Zubereitung, eines milchhaltigen Getränkes, insbesondere eines milchhaltigen Kaffeegetränkes verwandt werden. Ein entsprechendes Gerät ist vorzugsweise als Kaffeevollautomat ausgebildet.

Nachfolgend wird die Erfindung unter Bezug auf die Zeichnung anhand eines Ausführungsbeispiels näher beschreiben. Es zeigt:
- Fig. 1: eine schematische Darstellung des Aufbaus einer ersten erfindungsgemäßen Vorrichtung zum Herstellen von Milch-Luft-Emulsionen, insbesondere von Milchschaum;
- Fig. 2: ein Diagramm der elektrischen Leitfähigkeit von Milchschäumen mit verschiedenen Temperaturen und Luftanteilen; und
- Fig. 3: in a) bis d) weitere Diagramme zur Veranschaulichung von Varianten des erfindungsgemäßen Verfahrens.

Vorstehend sowie im Folgenden werden die Begriffe "Milch-Luft-Gemisch" und "Milch-Luft-Emulsion" und "Milchschaum" synonym verwendet.

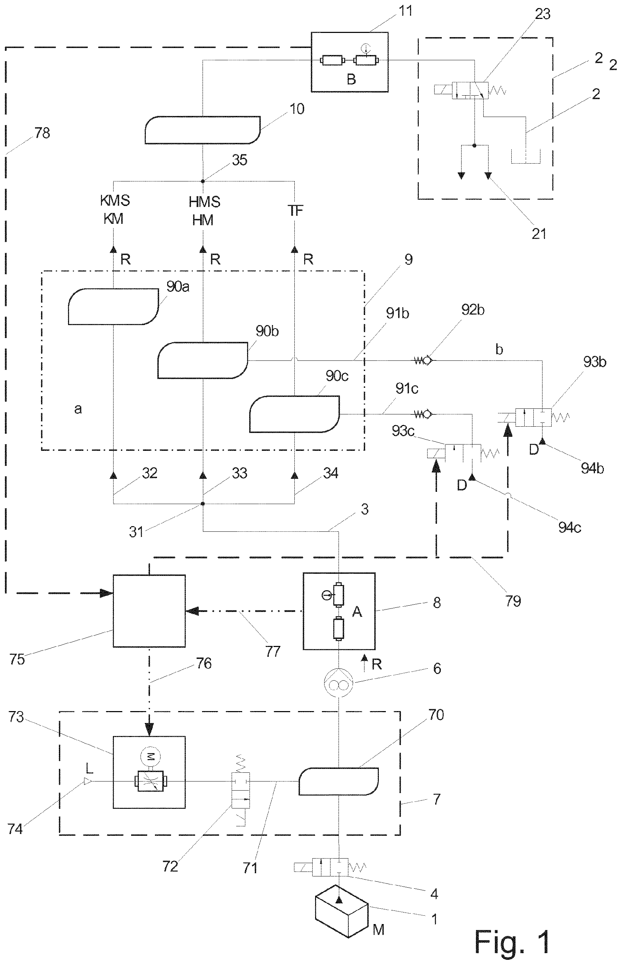

### Die Vorrichtung der Fig. 1 weist folgenden Aufbau auf:

Eine Milchleitung 3 verbindet einen Milchbehälter 1 mit Milch M und eine Auslassvorrichtung 2 miteinander. Die Auslassvorrichtung 2 ist als Auslauf ausgebildet, unter den ein Gefäß wie Tasse gestellt werden kann. Im Folgenden werden die Begriffe Auslassvorrichtung 2 und Auslauf synonym verwendet. Dabei sind in die Milchleitung 3 zwischen dem Milchbehälter 1 und der Auslassvorrichtung 2 in dieser Reihenfolge hier folgende Komponenten geschaltet:
ein Absperrventil 4, eine Milchpumpe 6, ein Luftzuführsystem 7, eine erste Messeinheit 8, eine Verarbeitungseinrichtung 9, sowie eine Nachbearbeitungsvorrichtung 10, und eine zweite Messeinheit 11.

Das Luftzuführsystem 7 weist eine Luftleitung 71 und ggf. eine Mischkammer 70 auf. In diese Mischkammer 70 wird die Milch über die Milchleitung 3 gefördert. Durch Lufteinleitung erfolgt ein Aufschäumen. Die Luftzufuhr kann mit einer Luftquelle 74 (z.B. einer Luftpumpe oder einem Druckbehälter oder einem nicht unter Druck stehenden Behälter oder durch eine Öffnung bzw. ein Leitungsende (saugend) mit der Umgebungsluft innerhalb oder außerhalb einer umgebenden Maschine) verbunden.

Zwischen der Mischkammer 70 und der Luftquelle 74 ist in oder an der Luftleitung 71 ein erstes Rückschlagventil 72 geschaltet. Zudem ist entlang der Luftleitung zwischen dem ersten Rückschlagventil 72 und der Luftquelle 74 eine Stelleinheit 73 angeordnet. Diese ermöglicht das Einstellen des Luftdrucks mit der die Luft durch die Luftleitung 71 in die Milch eingeblasen wird.

Dadurch wird zumindest ein Teil der Milch aufgeschäumt und es kommt zur Ausbildung einer Milch-/Luftemulsion.

Die Stelleinheit 73 empfängt von einer Regel- und Auswerteeinheit 75 einen Steuerbefehl, welcher über eine Signalleitung 76 an die Stelleinheit 73 übertragen wird. Die Signalleitung 76 kann beispielsweise als ein Kabel oder als eine drahtlose Verbindung ausgebildet sein.

Die erste Messeinheit 8 misst/ermittelt Messdaten zur Ermittlung einer physikalischen Stoffeigenschaft.

Diese Stoffeigenschaft ändert sich mit der Qualität des Milchschaumes, insbesondere dem Verhältnis von Luft zu Milch pro Kubikzentimeter Milchschaum.

Eine solche physikalische Stoffeigenschaft kann besonders bevorzugt die elektrische Leitfähigkeit sein. Der Wert der elektrischen Leitfähigkeit korreliert dem Anteil der Luft im Milchschaum. Neben der elektrischen Leitfähigkeit kann allerdings auch die thermische Leitfähigkeit, die Dichte und/oder die Viskosität ermittelt werden. Hierfür weist die erste Messeinheit 8 vorzugsweise einen Leitfähigkeitssensor auf. Weiterhin bevorzugt kann die erste Messeinheit einen Temperatursensor zur Temperaturkompensation der ermittelten Leitfähigkeit aufweisen. Zudem kann bevorzugt und vorteilhaft eine Anpassung der Temperatur der Milch- bzw. der Milch-Luft-Emulsion auf einen Sollwert durch Regulierung der Menge an zugeführter Kaltluft erfolgen.

Die erste Messeinheit 8 ist über eine Signalleitung 77, z.B. eine Kabelleitung oder eine drahtlose Datenleitung, mit der Regel- und Auswerteeinheit 75 verbunden und gibt die Messwerte an diese Regel- und Auswerteeinheit 75 weiter. Diese kann aus den Messdaten die entsprechende Stoffeigenschaft als ersten Istwert ermitteln und diese sodann mit einem vorgegebenen Sollwert eines Sollwertbereichs vergleichen.

Bei einem Über- oder Unterschreiten des Sollwertes kann die Luftmenge, welche in die Milch eingeleitet wird, durch die Stelleinheit 73 verändert werden, derart, dass ein zweiter Istwert innerhalb des erlaubten Sollbereichs liegt. Es können auch je nach ausgewähltem Heißgetränk mehrere Sollwerte für die jeweiligen Sollwertbereiche in einem Datensatz oder mehreren Datensätzen auf einem Datenspeicher der Regel- und/oder Auswerteeinheit hinterlegt sein. Zudem ist eine zentrale Recheneinheit vorgesehen, welche z.B. einen Vergleich zwischen Soll- und Istwerten spezifisch für das jeweilige Heißgetränk vornehmen kann.

Die Verarbeitungseinrichtung 9 weist Teilstränge der Milchleitung 3 mehrere Verarbeitungsleitungen 32, 33 und 34 auf. Hierfür können eines oder mehrere Umschaltventile, z.B. Zwei- oder Drei-Wegeventile 31 und 35 vorgesehen sein, welcher derart geschalten werden können, dass die Milch durch eine der Verarbeitungsleitungen 32, 33 oder 34 geleitet werden kann. Eine erste Verarbeitungsleitung 32 ist eine Durchleitung und weist keine Erwärmungseinheit (angedeutet dennoch durch ein Bezugszeichen: 90a) auf. Derart wird kalter Milchschaum weitergeleitet.

Eine zweite Verarbeitungsleitung 33 weist eine erste Erwärmungseinheit 90b auf, welche der direkten Erwärmung von Milch dient. Die erste Erwärmungseinheit 90b weist eine Heizleitung 91b auf, durch welche durch eine Dampferzeugungseinheit 94b Dampf D direkt in die Emulsion einleitbar ist. Hierfür ist ein Stellventil 93b vorgesehen. Zwischen dem Stellventil 93b und dem Punkt der Einleitung des Dampfes D in die Milch ist ein Rückschlagventil 92b angeordnet.

Eine dritte Verarbeitungsleitung 34 weist, alternativ oder zusätzlich zur ersten Erwärmungseinheit 90b zur direkten Erwärmung der Milch, eine zweite Erwärmungseinheit 90c auf, welche der indirekten Erwärmung von Milch dient.

Diese zweite Erwärmungseinheit 90c kann z.B. als eine Wärmeübertragungseinrichtung, insbesondere als ein Wärmetauscher, ausgelegt sein.

Der zweiten Erwärmungseinheit 90c kann eine Heizleitung 91 c zugeordnet sein, durch welche ausgehend von einer bzw. der Dampferzeugungseinheit 94c Dampf in die Erwärmungseinrichtung 90b zur indirekten Erwärmung einleitbar ist. Hierfür ist ein ansteuerbares Stellventil 93c vorgesehen, mit dem die Dampfzufuhr für Dampf D geöffnet und geschlossen werden kann. Zwischen dem Stellventil 93c und dem Punkt der Einleitung der Wärme des Dampfes D - insbesondere mittels eines Wärmetauschers - in die Milch ist ein Rückschlagventil 92c angeordnet.

Ein warmer Milchschaum (hier auch "TF" = Top Foam genannt) ist eine spezielle Milchschaumart, welche durch die definierten Anforderungen an Konsistenz, Stabilität, Thermorezeption und Optik, eine indirekte Erwärmung des kalten Milchschaums voraussetzt. (Eigenschaften die nicht durch das direkte Einbringen eines weiteren Mediums z.B. direkte Injektion vom Dampf D verändert werden). Vorzugsweise beträgt die Temperatur des kalten Milchschaums (KMS) < 30° C, des warmen Milchschaums (TF - T2) 40° bis 54° C und des heißen Milchschaums (HMS) 55° bis 80° C. Der heiße Milchschaum (HMS-T3) und die heiße Milch können mittels direkter Dampfinjektion sehr schnell sehr hoch erhitzt werden. (Hohe Ausgabeleistung bei hoher Temperatur (55-80 °C)).

Vorzugsweise ist die Verarbeitungseinrichtung 9 dazu ausgelegt, eine durchfließende Milch-Luft-Emulsion bzw. den kalten Milchschaum der Temperatur T1 auf eine Temperatur T2 zu erwärmen, die oberhalb der Temperatur T1 liegt, welche der kalte Milchschaum KMS aufweist und unterhalb der Temperatur T3, welche der heiße Milchschaum HMS aufweist. Derart wird der "warme" Milchschaum TF (Temperatur T2) erzeugt.

Die erste, zweite und dritte Verarbeitungsleitungen 32, 33, 34 können vorzugsweise als Dekompressionsleitungen ausgebildet sein. Dabei dient die erste Verarbeitungsleitung 32 der Erzeugung eines kalten Milchschaums kalter Temperatur T1, die zweite die Verarbeitungsleitung 33 mit der ersten Erwärmungseinheit 90b mit direkter Erwärmung kann der Erzeugung eines heißen Milchschaumes mit hoher Temperatur T3 dienen und die dritte Verarbeitungsleitung 34 mit der Erwärmungseinheit 90c kann der Erzeugung eines warmen Milchschaums mittlerer Temperatur T2 dienen, wobei folgende Beziehung gilt: T1 < T2 < T3. Die Verarbeitungsleitungen 32, 33, 34 sind hier parallel geschaltet.

Selbstverständlich ist es auch möglich einzelne Verarbeitungsleitungen, insbesondere die Verarbeitungsleitungen 33 und 34 zu einer einzigen Verarbeitungsleitung mit einer Möglichkeit zur Erwärmung, insbesondere zur Dampfeinleitung, zusammenzufassen. Es können derart auch alle drei Verarbeitungsleitungen 32-34 zu einer Verarbeitungsleitung zusammengefasst werden.

Insgesamt können heiße, warme und kalte Milch, je nach Nutzen von Heißdampf bei direkter Erwärmung, indirekte Erwärmung oder keiner Erwärmung, ausgegeben werden. Nach einer Variante werden in einen zunächst bereitgestellten Kaffee zwei verschieden temperierte Milchschäume gegeben oder es werden erst die zwei verschieden temperierten Milchschäume bereitgestellt und es wird dann ein Kaffee dazu gegeben.

Es kann derart z.B. auch eine kombinierte Heiß/Kalt-Verarbeitungsleitung 32/33 geschaffen werden bzw. vorgesehen sein und eine gesonderte Warm-Verarbeitungsleitung 34 mit indirekter Erwärmung des Milchschaumes bereitgestellt werden. Durch die Verarbeitungsleitung 34 fließt in diesem Fall somit ausschließlich warmer Milchschaum TF und die zusammengefasste Verarbeitungsleitung 32/33 fließt kalter oder heißer Milchschaum KMS, HMS oder heiße Milch HM oder kalte Milch KM ohne Schaum.

Die Erwärmungseinheit 90b beruht auf Erwärmung durch direktes Einleiten von Dampf. Die Erwärmungseinheit 90c kann vorzugsweise als ein dampfbetriebener oder wahlweise/vorzugsweise fluidbetriebener indirekter Wärmeüberträger ausgebildet sein, welcher wenn aktiviert, die Milch-Luft-Emulsion indirekt auf eine Temperatur T2 erwärmt. Die Temperatur T2 liegt vorzugsweise zwischen 40 °C und 54 °C.

Die indirekt wirkende Erwärmungseinheit 90c kann in verschiedenster Weise, so z.B. als Mantelrohr-Wärmeüberträger als Schicht-Wärmeüberträger oder als Spiralrohr- Wärmeüberträger, ausgebildet sein. Die Wärmeübertragung findet nach der Herstellung des kalten Milchschaums vor der Ausgabe statt. Vorteilhaft ist, wenn der warme Schaum TF mit der Temperatur T2 wie der kalte Milchschaum KMS mit der Temperatur T1 und der heiße Schaum HMS mit der Temperatur T3 einer optionalen Nachbehandlung in einer Nachbehandlungseinrichtung, insbesondere in einem Homogenisator 10, unterzogen werden.

Die eingebrachte Wärmeenergie der indirekt wirkenden Erwärmungseinheit 90c wird vorzugsweise über eine oder mehrere Kontaktheizflächen an den Milchschaum übertragen, in dieser Funktion ist zur Vergrößerung der Kontaktfläche und somit Wärmeübertragung auch ein zusätzlicher innerer oder äußerer Erwärmungskanal denkbar, sowie die Abfrage der Temperatur, im inneren des Elements, mit einem Fühler. Vorzugsweise dient Wasserdampf als Wärmeträger.

Die Konsistenz des noch kalten Milchschaums KMS mit der Temperatur T1, der aus der Pumpe 6 strömt, kann durch Einstellen der Fördermenge der Milchpumpe 6, insbesondere von der Milchpumpendrehzahl, verändert werden. Dies kann jedoch direkten Einfluss auf die Förderleistung und die Ausgabemenge haben. Die Luftmenge wird vorteilhaft durch Verändern der einstellbaren Drossel 72, welche bevorzugt als automatisch einstellbares Nadelventil ausgebildet ist, geändert.

Es ist ferner vorteilhaft, wenn sämtliche Abschnitte von Kaltwasser spülbar sind, wozu entsprechende Zuleitungen und Ventile vorgesehen sein können (hier nicht dargestellt).

Im Anschluss an die Verarbeitungseinrichtung 9 ist die Nachbearbeitungsvorrichtung 10, vorzugsweise mit einem Homogenisator, in der Milchleitung 3 angeordnet.

Bei bekannten Kaffeevollautomaten ist die Konsistenz des Milchschaums, und hier in erster Linie die Ausbildung der Luftblasen, oftmals sehr unregelmäßig. Durch den Homogenisator kann der erzeugte Milchschaums vorteilhaft vergleichmässigt werden. Nach einer besonders bevorzugten Variante wird zur Nachbehandlung des Milchschaumes ein Homogenisator geschaffen, der zum Verkleinern der Luftblasen eines Milchschaumes im Sinne einer Luft-/Milchemulsion bzw. eines Milch-Luftgemisches vorgesehen ist. Ein solches Milch-/Luftgemisch umfasst eine definierte Menge Milch, der eine definierte Menge Luft zugeführt ist. Optional enthält ein solches Milch-/Luftgemisch zudem eine definierte Menge (Heiß-)Dampf (Wasser). Mit dem Homogenisator ist die Konsistenz eines Milchschaumes optimierbar. Sie ist insbesondere - durch Variation des Druckes am Eingang - die Konsistenz des Milchschaumes von fein, d. h. mit sehr kleinen Luftblasen, bis grob, d. h. mit großen Luftblasen, und von locker über cremig bis fest veränderbar. Der Homogenisator ist bevorzugt für einen Heißgetränkeautomaten, besonders bevorzugt für einen Kaffeevollautomaten, vorgesehen. Er weist bevorzugt einen Verkleinerungsbereich auf, in dem eine Vielzahl von Prallkörpern angeordnet ist. Zwischen den Prallkörpern erstreckt sich ein Kanallabyrinth, welches vorgesehen ist, um von dem Milch-/Luftgemisch durchströmt zu werden. Das Milch-/Luftgemisch kann in Teilströmen durch das Kanallabyrinth gedrückt werden. Dafür sind bevorzugt mehrere Prallkörper nebeneinander in einer Reihe angeordnet. Weiterhin bevorzugt weisen die Prallkörper dafür jeweils eine Prallfläche auf, auf die die Teilströme des Milchschaumes jeweils beim Durchströmen des Kanallabyrinthes aufprallen. Beim Aufprall teilen sich die Teilströme, und die Luftblasen werden zerteilt. Dadurch entstehen kleinere Luftblasen. Zudem ist es bevorzugt, dass der Homogenisator in seiner Erstreckungsrichtung, die die Strömungsrichtung des Milchschaumes ist, mehrere untereinander angeordnete Reihen mit Prallkörpern aufweist. Dadurch prallen die Teilströme jeweils auf die Prallkörper der in Erstreckungsrichtung untereinander angeordneten Reihen auf, so dass die Luftblasen mehrfach verkleinert werden.

Im Anschluss an die Nachbearbeitungsvorrichtung ist eine zweite Messeinheit 11 angeordnet. Diese zweite Messeinheit 11 weist vorzugsweise einen Sensor zur Ermittlung der vorgenannten physikalischen Stoffeigenschaft, insbesondere einen Leitfähigkeitssensor, auf und/oder einen Sensor zur Ermittlung der Temperatur der Milch auf.

Die meisten physikalischen Stoffeigenschaften sind temperaturabhängige Stoffeigenschaften. So ist beispielsweise die elektrische Leitfähigkeit abhängig von der Temperatur und dem Luftgehalt. Sie eignet sich daher im Rahmen der Erfindung sehr gut als Meß- und Regelgröße zur Beeinflussung der Milchschaumqualität. Zudem ist es für die Zubereitung von Heißgetränken besonders interessant zu ermitteln, ob die Zieltemperatur des Heißgetränkes erreicht ist, bzw. ob ein ermittelter Istwert des Heißgetränkes innerhalb eines vorgegebenen Sollwertbereiches liegt. Entsprechende Sollwerte können spezifisch für das jeweilige Heißgetränk als Datensatz auf dem Datenspeicher der Regel- und Auswerteeinheit 75 hinterlegt sein.

Entsprechend ist die zweite Messeinheit über eine Signalleitung 78 mit der Regel- und Auswerteeinheit 75 verbunden, welche Signalleitung z.B. als Kabel- oder wireless-Verbindung ausgebildet sein kann. Somit werden Messdaten zur Ermittlung der physikalischen Stoffeigenschaft durch die zweite Messeinheit 11 erfasst und/oder es werden aktuelle Temperaturen als Messdaten der Milch bzw. des Milchschaumes durch die zweite Messeinheit erfasst. Diese Messdaten werden sodann durch die Signalleitung 78 an die Regel- und Auswerteeinheit 75 übermittelt.

Diese erstellt für den Fall, dass die Messdaten oder die daraus ermittelten Stoffeigenschaften und/oder Temperaturen, außerhalb eines bestimmten Sollwertbereiches liegen einen Steuerbefahl 79 zur Regulierung eines oder mehrerer der Stellventile 93b, 93c der ersten und oder zweiten Heizleitung 90b und/oder 90c. Alternativ oder zusätzlich und nicht dargestellt kann auch eine Regulierung eines oder beider Umschaltventile 31, 35 durch die Regel- und Auswerteeinheit 75 erfolgen. Dadurch kann insbesondere eine Einstellung der Temperatur der Milch auf eine Zieltemperatur innerhalb des Sollwertbereichs erreicht werden und der Milchschaumqualität kann bei dieser Zieltemperatur durch Ermittlung der Leitfähigkeit überprüft und durch Nachregelung entsprechend eingestellt werden.

Das vorbeschriebenen Luftzuführsystem 7 dient vorzugsweise zur Luftzuführung nach einem Verfahren mit den folgenden Schritten:
a) Fördern von Milch in einer Milchleitung mittels der Milchpumpe, und gleichzeitig Ansaugen von Luft durch eine Luftleitung, wobei zur Veränderung der angesaugten Luftmenge zumindest eine Drossel verwendet wird,
b) Mischen von Milch und Luft in einer ersten Mischkammer zum Erzeugen einer Luft-Milch-Emulsion,
c) ggf. Zusetzen von Dampf zur Luft-Milch-Emulsion zum Erwärmen der Luft-Milch-Emulsion (vorzugsweise nach Schritt b), wenn ein warmer Milchschaum erzeugt werden soll,
d) wobei in Schritt a) eine solche Drossel verwendet wird, die hinsichtlich der Größe ihres Öffnungsquerschnitts stufenlos, insbesondere mittels eines Elektromotors (M), einstellbar ausgebildet ist, wobei und vorzugsweise ein Schliessen der Schließen der Luftleitung dadurch realisierbar wird, dass mit der einstellbaren Drossel der Öffnungsquerschnitt geschlossen wird.

Die Drossel ist dabei als eine Ausführungsvariante einer Stelleinheit 73 zu verstehen.

Der Öffnungsquerschnitt der Drossel kann erfindungsgemäß nach der Leitfähigkeit und/oder nach der gewünschten Temperatur des Milchschaumes eingestellt werden.

Die in Schritt a) verwendete Drossel kann hinsichtlich der Größe ihres Öffnungsquerschnitts stufenlos einstellbar ausgebildet sein. Die stufenlose Einstellung des Öffnungsquerschnitts der Drossel ermöglicht die Einstellung der der Milch zugeführten Luftmenge in Abhängigkeit von dem gewünschten Milch- Luft Gemisch. Dadurch können mit nur einer einstellbaren Drossel Milch- Luft- Gemische, insbesondere Milchschäume, mit unterschiedlichen Eigenschaften hergestellt werden. Der Öffnungsquerschnitt der Drossel kann vorzugsweise während der Herstellung des warmen Milch- Luft- Gemisches bevorzugt kleiner, als bei der Herstellung des kalten Milch- Luft- Gemisches. Weiterhin kann die Konsistenz des Milch-LuftGemisches weitgehend unabhängig von der Temperatur durch Änderung des Öffnungsquerschnitts variiert werden.

Eine Drossel, die hinsichtlich der Größe ihres Öffnungsquerschnitts stufenlos, insbesondere mittels eines Elektromotors, einstellbar ausgebildet ist, wird im Folgenden als einstellbare Drossel bezeichnet.

Für die Einstellung des Öffnungsquerschnitts der einstellbaren Drossel kann bevorzugt ein Elektromotor verwendet werden. Eine einstellbare Drossel, wie sie in der vorliegenden Erfindung bevorzugt als Stelleinheit 73 vorgesehen sein kann, kann dabei auch eine quasi- stufenlose Einstellung aufweisen, die beispielsweise ein Schrittmotor ermöglicht wird.

Alternativ oder zusätzlich zur Regelung der zugeführten Luftmenge kann die Regel- und Auswerteeinheit 75 auch bevorzugt die Förder- und Pumpmenge der Milchpumpe 6 in Abhängigkeit der physikalischen Stoffeigenschaft, insbesondere elektrischen Leitfähigkeit, regeln. Auch dadurch ist die Konsistenz des Milchschaums veränderbar.

Durch die Verwendung einer einstellbaren Drossel als Stelleinheit in Kombination mit der Möglichkeit der Regelung der verschiedenen Erwärmungseinheiten ist die zugeführte Luftmenge in Abhängigkeit einer physikalischen Stoffeigenschaft, insbesondere in Abhängigkeit von der Leitfähigkeit und der Temperatur des hergestellten Milch- Luft- Gemisches einstellbar.

Die Auslassvorrichtung 2 kann ein Ventil 23 und Ausgabedüsen 21 aufweisen und eine Lanze 22 zur Ausgabe von Heißwasser und/oder Heißdampf z.B. für ein manuelles Aufschäumen.

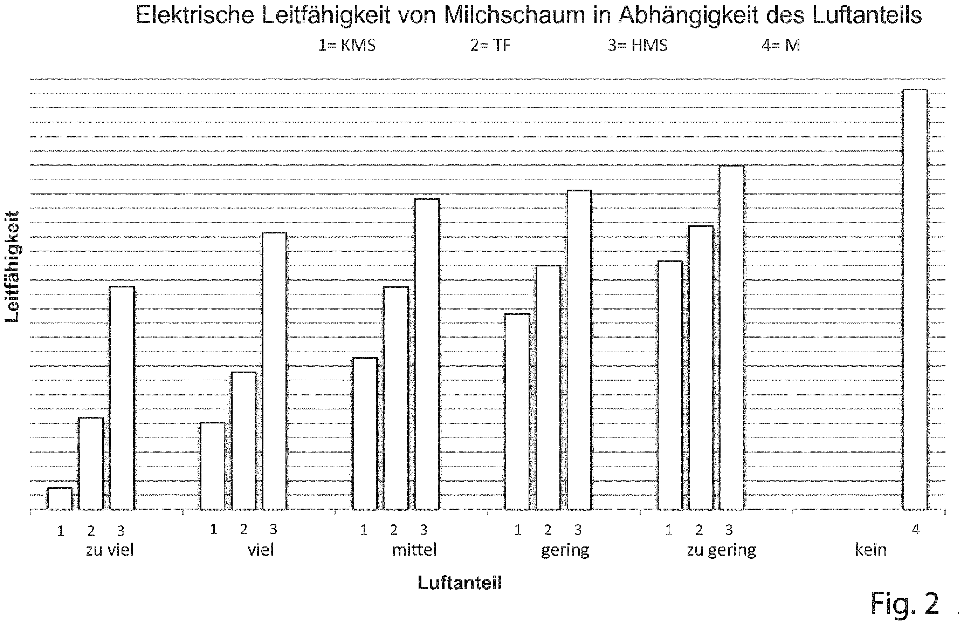

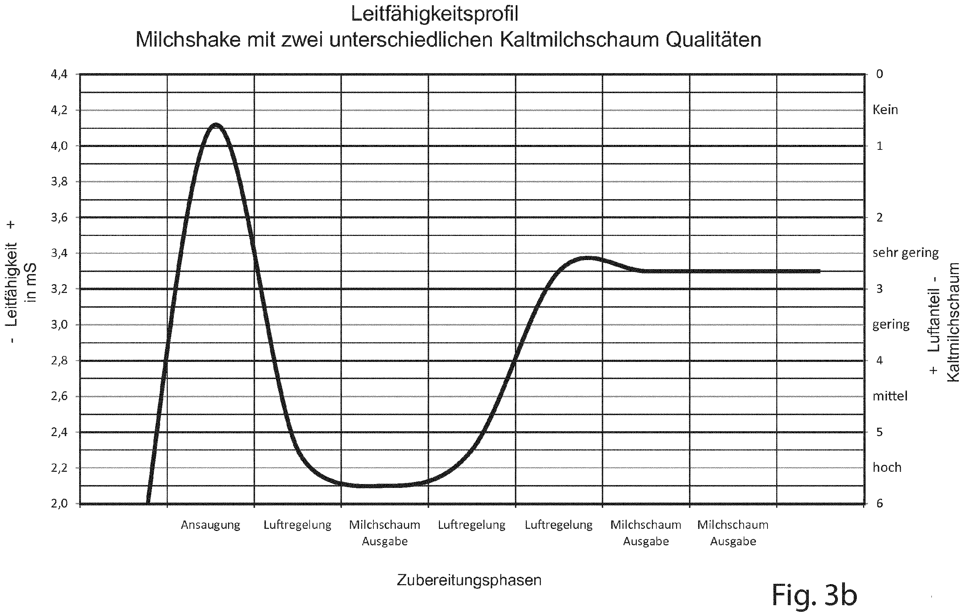

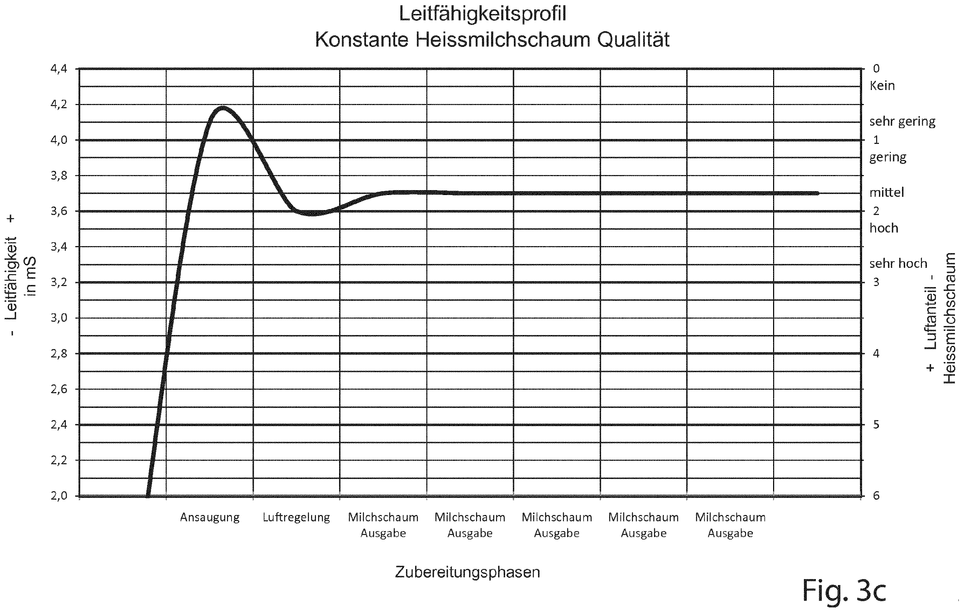

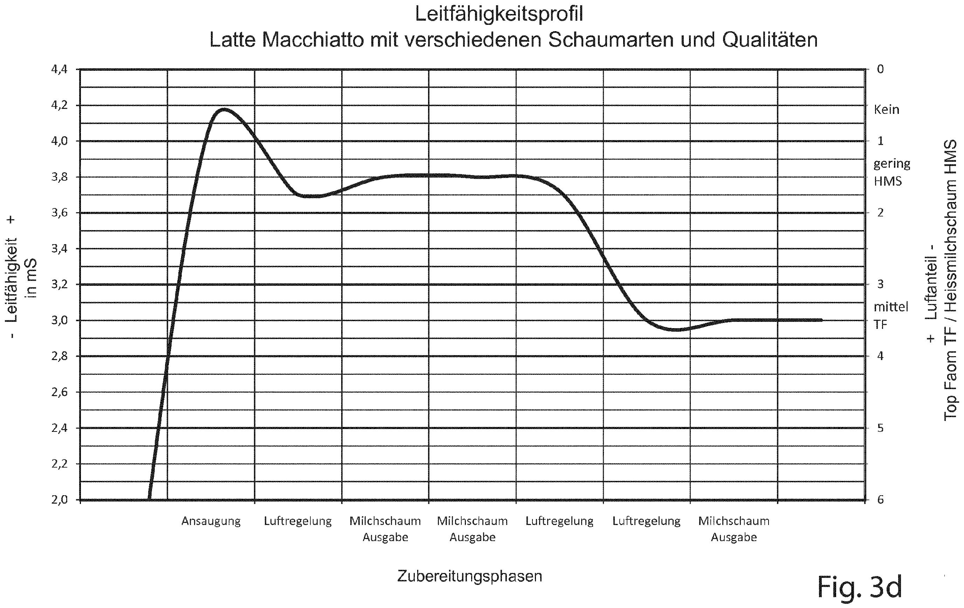

Fig. 2 stellt beispielhaft schematisch eine Abhängigkeit zwischen der elektrischen Leitfähigkeit und dem Luftanteil in Milch (Milchsorte: Kuhmilch, 1,5% Fett, UHT) mit einer Eingangstemperatur von 3-5°C dar. Die Ziffer 1 beschreibt hier einen Milchschaum bei etwa 3-5°C. Die Ziffer 2 beschreibt hier einen warmen Milchschaum bei etwa 45°C und die Ziffer drei beschreibt einen heißen Milchschaum bei 65°C. Man erkennt eine Abhängigkeit der Leitfähigkeit von der Temperatur des Milchschaumes und von dem Luftanteil. Durch Anpassung der Stellgrößen Luftdruck, Temperatur und Zeitraum der Aufschäumung kann die Schaumqualität beeinflusst werden. Die Qualität des Schaumes ist durch die elektrische Leitfähigkeit bestimmbar. Dies wird weiter unten im Rahmen er Beschreibung der Fig. 3 anhand von Beispielen noch näher erläutert.

Insgesamt kann durch die Vorrichtung der Fig. 1 die elektrische Leitfähigkeit von Milchschaum genutzt werden um diesen Milchschaum zu beurteilen und diesen über die zugeführte Luftmenge zu beeinflussen. Ein zusätzlicher vorteilhaft zu berücksichtigender Parameter ist die Temperatur. Denn die Leitfähigkeit des Milchschaumes ist insbesondere abhängig von der Milchsorte, der Milchtemperatur und dem Luftanteil. Mit der entsprechenden Messung und den Kenntnissen über die Leitfähigkeitscharakteristik verschiedener Milchsorten und Temperaturen, welche u.a. in Sollwert-Datensätzen berücksichtigt werden können, kann ein optimales Milch-zu Luftverhältnis für die weitere Verarbeitung im Prozess definiert und dieses beispielsweise über die automatische Regulierung der Luftzufuhr hergestellt werden. Die Luftmengen können sogar dynamisch individuell reguliert werden. Die Regulierung kann sich automatisch den internen und externen Parametern anpassen, was eine Reaktion auf die Veränderungen der Betriebsbedingungen grundsätzlich ermöglicht und die Justierung und Kalibrierung des Systems stark vereinfacht. Veränderungen der Milchtemperatur können in begrenztem Maße durch die Zufuhr an Luft kompensiert werden.

Die vorbeschriebenen eingesetzten Messeinheiten umfassen jeweils bevorzugt einen Leitfähigkeitssensor und einen Temperatursensor.

Besonders bevorzugt ist die erste Messeinheit 8 direkt druckseitig der Milchpumpe 6 angeordnet.

Alternativ oder zusätzlich kann die erste Messeinheit 11 (oder eine weitere Messeinheit), wie in Fig. 1 dargestellt, hinter der Nachbearbeitungsvorrichtung 10 angeordnet sein.

Somit ist es beispielsweise möglich die Rohmilchtemperatur zu messen und vor Qualitätseinbußen zu warnen. Alternativ oder zusätzlich ist es möglich heiße Milch oder heißen Milchschaum temperaturabhängig einzustellen.

Die vorgenannte Regulierung kann im Rahmen eines selbstjustierenden Systems am Installationsort vorgenommen werden. Ein Servicetechniker kann die eingestellten Getränke-Produkte kontrollieren und auf Kundenwunsch Anpassungen beim Einspielen von Sollwert-Datensätzen vornehmen, so dass die gewünschten Produkte an den Endkunden ausgegeben werden können.

Wie bereits erläutert, stellt Fig. 2 beispielhaft schematisch eine Abhängigkeit zwischen der elektrischen Leitfähigkeit und dem Luftanteil in Milch (Milchsorte: Kuhmilch, 1,5% Fett, UHT) mit einer Eingangstemperatur von 3-5°C dar. Diese Abhängigkeit der Leitfähigkeit von der Temperatur des Milchschaumes und von dem Luftanteil durch Anpassung der Stellgrößen Luftdruck, Temperatur und Zeitraum der Aufschäumung wird in den Beispielen der Fig. 3 jeweils genutzt, um unterschiedliche Milchschaumqualitäten zu erzeugen, die hervorragend auf das jeweilige Getränk abgestimmt sind. Auch diese Qualitäten sind nur beispielhaft zu verstehen.

In den beispielhaften Diagrammen der Fig. 3 sind jeweils von links nach rechts hin verschiedene Zubereitungsphasen bei der Zubereitung verschiedener Getränke aufgetragen bzw. angegeben, die mit einem oder mehreren verschiedenen Milchschäumen versehen werden sollen. Di8e Zubereitung ist beispielhaft vorteilhaft gestaltet, kann aber auch anders gestaltet werden, d.h., beispielsweise Milchschaum-Arten können nach Wunsch variiert werden.

Nach oben hin ist in den Diagrammen links die Leitfähigkeit in mS angetragen und rechts an dem Diagramm die damit im Zusammenhang stehende Parameter Luftanteil. Es wird dabei je Diagramm eine konstante Temperatur angenommen, die aber in den verschiedenen Diagrammen nicht gleich ist. Die verwendete Milch ist eine UHT-Milch mit einem Fettanteil von 1,5% (Fettanteil gemessen bei 3° C bis 5° C).

Auf der primären linken vertikalen Achse sind die in Vorversuchen ermittelten Messwerte der Leitfähigkeit in Abhängigkeit des Luftanteils für 3°C - 5°C kalte UHT Milch mit 1,5% Fettgehalt aufgeführt. Diese Werte variieren in Abhängigkeit von Temperatur und Milchsorte und werden im Versuch ermittelt und abgespeichert. Sie hängen auch von den jeweiligen Randbedingungen ab, so beispielsweise von der Messart und dem Messort und der Temperatur. Die Zielregelbereiche werden entsprechend zugehörig ermittelt und abgespeichert.

Auf der horizontalen Achse sind die Ziel-Leitfähigkeiten der verschiedenen Zubereitungsphasen des Milchprodukts aufgeführt. Auf der sekundären rechten vertikalen Achse ist das Milch-Luftverhältnis als anteilige Luftmenge für die jeweilige Milchschaumart aufgeführt. Für einen Top Foam (= Milchschaum) aus 3°C - 5°C kalte UHT Milch mit 1,5% Fettgehalt liegt der Regelbereich für einen eher flüssigen Schaum "geringer Luftanteil" zwischen 3,2 und 3,6 mS. Durch die Skala von 1 - 6 und den entsprechend dazwischenliegenden Stellbereichen kann eine grundsätzliche Abhängigkeit von Leitfähigkeit und Luftanteil dargestellt werden.

Das Diagramm bzw. Profil der Fig. 3a beschreibt beispielhaft die Herstellung eines Cappuccino mit zwei unterschiedlichen Top Foam bzw. Milchschaum-"Qualitäten".

Nach dem Ansaugen (Vorhandensein von Milch) wird das System zuerst auf einen Top Foam (=Milchschaum) mit geringem Luftanteil geregelt, welcher sich mit dem Espresso mischt und dabei den charakteristischen Geschmack ergibt. Anschließend wird das System auf einen Top Foam (=Milchschaum) mit hohem Luftanteil geregelt, welcher auf Grund seiner geringeren Dichte auf dem Getränk schwimmt und dabei die optische Erscheinung bestimmt.

Das Diagramm bzw. Profil der Fig. 3b beschreibt beispielhaft die Herstellung eines Milchshakes zwei unterschiedlichen Kalt-Milchschaum-Qualitäten.

Nach der Ansaugung (Vorhandensein von Milch) wird das System zuerst auf einen Kalt-Milchschaum mit hohem Luftanteil geregelt. Anschließend wird das System auf einen Kalt-Milchschaum mit einem sehr geringem Luftanteil geregelt, welcher sich auf Grund seiner größeren Dichte unten in dem Gefäß absetzt.

Das Diagramm bzw. Profil der Fig. 3c beschreibt beispielhaft die Herstellung eines Heiß-Milchschaum mit einer konstanten Milchschaum-Qualität, der z.B. nachträglich auf einen bereits - beispielsweise versehentlich ohne Schaum - zubereiteten Kaffee aufgegeben werden kann.

Nach der Ansaugung (Vorhandensein von Milch) wird das System auf einen Heiß-Milchschaum mit einem mittleren Luftanteil geregelt, der sich teilweise mit dem Kaffee vermischt und teilweise auf dem Kaffee absetzt.

Das Diagramm bzw. Profil der Fig. 3d beschreibt beispielhaft die Herstellung eines Latte Macchiatto mit zwei unterschiedlichen Milchschaum-"Qualitäten".

Nach der Ansaugung (Vorhandensein von Milch) wird das System zuerst auf einen Heiß-Milchschaum (Mischung für Geschmack) mit geringer Luftzugabe geregelt, welcher sich mit dem zubereiteten Kaffee mischt und dabei den charakteristischen Geschmack ergibt. Anschließend wird das System auf einen Milchschaum mit mittlerem Luftanteil geregelt, welcher auf Grund seiner geringeren Dichte teilweise auf dem Getränk aufschwimmt (TOP FOAM) und so die optische Erscheinung des Latte Macchiatto bestimmt.

Gemessen wird insofern jeweils die Leitfähigkeit des jeweils erzeugten Milchschaums und es erfolgt ein Regeln des Luftanteils in der Milch-Luft-Emulsion - hier im Milchschaum - in Abhängigkeit von der aktuell gemessenen Leitfähigkeit unter Nutzung des abgespeicherten, im Versuch ermittelten Profils nach Art der beanspruchten und vorstehend beschriebenen Weise. Besonders vorteilhaft ist dabei, wenn die Vorrichtung einen Temperatursensor aufweist, welcher in Durchflussrichtung R der Milch bzw. Milch- Luft-Emulsion nach der Verarbeitungseinrichtung 9 angeordnet ist und welcher die Temperatur der Milch-Luft-Emulsion ermittelt, wobei die Regel- und Auswerteeinheit vorzugsweise eine Temperaturkompensation der ermittelten physikalischen Stoffeigenschaft - insbesondere der Leitfähigkeit - vornimmt. Denn derart kann mit Hilfe einer Temperaturinformation und der Leitfähigkeitsinformation auf einfache Weise optimal die jeweilige Schaumqualität eingeregelt werden.

Es ist auch möglich und sinnvoll, ein auf einer Maschine vorgespeichertes Profil nach Art der Fig. 3 a) bis d) beim Kunden jeweils an die verwendete Milch anzupassen.

**Bezugszeichenliste**

| | |
|---|---|
| Milchbehälter | 1 |
| Auslassvorrichtung | 2 |
| Ausgabedüsen | 21 |
| Lanze | 22 |
| Ventil | 23 |
| Milchleitung | 3 |
| Drei-Wegeventil | 31 |
| Verarbeitungsleitung | 32 |
| Verarbeitungsleitung | 33 |
| Verarbeitungsleitung | 34 |
| Drei-Wegeventil | 35 |
| Absperrventil | 4 |
| Mischkammer | 5 |
| Milchpumpe | 6 |
| Luftzuführsystem | 7 |
| Mischkammer | 70 |
| Luftleitung | 71 |
| Rückschlagventil | 72 |
| Stelleinheit | 73 |
| Luftquelle | 74 |
| Regel- und Auswerteeinheit | 75 |
| Signalleitung | 76 |
| Signalleitung | 77 |
| Signalleitung | 78 |
| Signalleitung | 79 |
| Erste Messeinheit | 8 |
| Verarbeitungseinrichtung | 9 |
| Keine Erwärmungseinheit | 90a |
| Erste Erwärmungseinheit | 90b |
| Zweite Erwärmungseinheit | 90c |
| Heizleitung | 91b |
| Heizleitung | 91c |
| Rückschlagventil | 92b |
| Rückschlagventil | 92c |
| Stellventil | 93b |
| Stellventil | 93c |
| Dampferzeugungseinrichtung | 94b |
| Dampferzeugungseinrichtung | 94c |
| Nachbearbeitungsvorrichtung, | 10 |
| Homogenisator | |
| Zweite Messeinheit | 11 |

## Patentansprüche

1. Verfahren, mit dem Milch-Luft-Emulsionen, insbesondere Milchschäume, mit einer Vorrichtung zum Erzeugen eines Milchschaums hergestellt werden, wobei die Vorrichtung zumindest aufweist:
a) eine von Milch durchflossenen Milchleitung (3),
b) wenigstens ein Luftzuführsystem (7) zur Erzeugung einer Milch-Luft-Emulsion aus der Milch,
c) eine Verarbeitungseinrichtung (9) zur Erwärmung einer Milch-Luft-Emulsion erster Temperatur T1,
d) zumindest eine erste Messeinheit (8 oder 11) zur Ermittlung wenigstens einer physikalischen Stoffeigenschaft der Milch-Luft-Emulsion, und
e) eine Regel- und Auswerteeinheit (75), welche ausgerüstet ist zur Einstellung einer Steuergröße anhand der physikalischen Stoffeigenschaft der Milch-Luft-Emulsion, wobei die Regel- und Auswerteeinheit (75) einen Datenspeicher aufweist, auf welchem Datensätze von Sollwerten und/oder Sollwertbereichen in Abhängigkeit von der Temperatur und/oder einem gewünschten milchhaltigen Getränk und/oder einer zugeführten Milchsorte hinterlegt sind,
wobei das Verfahren zumindest folgende Schritte aufweist:
A) Ermitteln der physikalischen Stoffeigenschaft der Milch-Luft-Emulsion durch zumindest die erste Messeinheit (8 oder 11);
B) Durchführen eines Vergleiches mit der Regel- und Auswerteeinheit (75) zwischen einem Ist-Wert und einem Sollwertbereich dieser physikalischen Stoffeigenschaft, wobei die Regel- und Auswerteeinheit (75) einen Datenspeicher nutzt, auf welchem Datensätze von Sollwerten und/oder Sollwertbereichen in Abhängigkeit von der Temperatur und/oder einem gewünschten milchhaltigen Getränk und/oder einer zugeführten Milchsorte hinterlegt sind,
C) wobei, sofern der Istwert außerhalb des Sollwertbereiches liegt, mit der Regel- und Auswerteeinheit (75) ein Einstellen zumindest einer Stellgröße im Verfahren erfolgt, derart, dass die physikalische Stoffeigenschaft beeinflusst wird, **dadurch gekennzeichnet, dass**
D) die Regel- und Auswerteeinheit (75) während eines Bezuges ein nicht konstantes und während des Bezuges veränderbares Profil von Sollwerten und/oder Sollwertbereichen bestimmt und danach die Regelung vornimmt.

2. Verfahren nach Anspruch 1, **dadurch gekennzeichnet, dass** die wenigstens eine physikalische Stoffeigenschaft die elektrische Leitfähigkeit der Milch-Luft-Emulsion ist.

3. Verfahren nach Anspruch 1 oder 2, **dadurch gekennzeichnet, dass** das Einstellen der Stellgröße eine Regelung des Luftdruckes der durch das Luftzuführsystem zugeführten Luft umfasst.

4. Verfahren nach einem der vorhergehenden Ansprüche, **dadurch gekennzeichnet, dass** das Einstellen der Stellgröße eine Regelung des Durchflusses der Milch oder der Milch-Luft-Emulsion durch die Milchleitung (3), vorzugsweise eine Regelung des Durchflusses der Milch oder der Milch-Luft-Emulsion durch eine Mischkammer, in welcher die Milch-Luft-Emulsion gebildet wird, umfasst.

5. Verfahren nach einem der vorhergehenden Ansprüche, **dadurch gekennzeichnet, dass** das Einstellen der Stellgröße ein Einstellen der Verarbeitungseinrichtung (9), insbesondere einer Erwärmungseinrichtung der Verarbeitungseinrichtung (9), umfasst.

6. Verfahren nach einem der vorhergehenden Ansprüche, **dadurch gekennzeichnet, dass** die Vorrichtung die erste Messeinheit (8) und eine zweite Messeinheit (11) aufweist, wobei die Messeinheit (8) zwischen dem Luftzuführsystem (7) zur Erzeugung der Milch- Luft-Emulsion und der Verarbeitungseinrichtung (9) zur Erwärmung der Milch- Luft-Emulsion angeordnet ist und wobei die zweite Messeinheit (11) in Durchflussrichtung R der Milch bzw. Milch- Luft-Emulsion hinter der Verarbeitungseinrichtung (9) angeordnet ist, wobei die physikalische Stoffeigenschaft vor und nach der Erwärmung der Milch- Luft-Emulsion bestimmt wird.

7. Verfahren nach einem der vorhergehenden Ansprüche, **dadurch gekennzeichnet, dass** die Vorrichtung einen Temperatursensor aufweist, welcher in Durchflussrichtung R der Milch bzw. Milch- Luft-Emulsion nach der Verarbeitungseinrichtung (9) angeordnet ist und welcher die Temperatur der Milch-Luft-Emulsion ermittelt, wobei die Regel- und Auswerteeinheit vorzugsweise eine Temperaturkompensation der ermittelten physikalischen Stoffeigenschaft vornimmt.

8. Verfahren nach Anspruch 7, **dadurch gekennzeichnet, dass** der Temperatursensor oder jeweils einer der Temperatursensoren Bestandteil der ersten und/oder der zweiten Messeinheit ist.

9. Verfahren nach einem der vorhergehenden Ansprüche, **dadurch gekennzeichnet, dass** die Verarbeitungseinrichtung (9) zumindest eine Heizleitung (91b oder 91c) zur Erwärmung der Milch-Luft-Emulsion aufweist, in welcher ein Heizmedium, vorzugsweise Dampf, geführt ist, wobei die Heizleitung (91b oder 91c) zumindest ein Stellventil (93b oder 93c) zur Regulierung des Durchflusses des Heizmediums in der Heizleitung (91b oder 91c) aufweist, wobei das Stellventil (93b oder 93c) in Abhängigkeit von der ermittelten Temperatur des Temperatursensors und/oder in Abhängigkeit von der ermittelten physikalischen Stoffeigenschaft geregelt wird.

10. Verfahren nach einem der vorhergehenden Ansprüche, **dadurch gekennzeichnet, dass** die Verweilzeit der Milch-Luft-Emulsion in der Verarbeitungseinrichtung (9) in Abhängigkeit der ermittelten physikalischen Stoffeigenschaft eingestellt wird

11. Vorrichtung zur Erzeugung von Milch-Luft-Emulsionen, insbesondere von Milchschäumen, vorzugsweise nach einem Verfahren gemäß einem der vorhergehenden Ansprüche, mit
a) einer von Milch durchflossenen Milchleitung (3),
b) wenigstens einem Luftzuführsystem (7) zur Erzeugung einer Milch-Luft-Emulsion,
c) einer Verarbeitungseinrichtung (9) zur Erwärmung einer Milch-Luft-Emulsion erster Temperatur T1,
d) zumindest einer ersten Messeinheit (8 oder 11) zur Ermittlung einer physikalischen Stoffeigenschaft der Milch-Luft-Emulsion, und
e) eine Regel- und Auswerteeinheit (75), welche ausgerüstet ist zur Einstellung einer Steuergröße anhand der physikalischen Stoffeigenschaft der Milch-Luft-Emulsion, wobei die Regel- und Auswerteeinheit (75) einen Datenspeicher aufweist, auf welchem Datensätze von Sollwerten und/oder Sollwertbereichen in Abhängigkeit von der Temperatur und/oder einem gewünschten milchhaltigen Getränk und/oder einer zugeführten Milchsorte hinterlegt sind,
**dadurch gekennzeichnet, dass**
f) die Regel- und Auswerteeinheit (75) während eines Bezuges ein nicht konstantes und während des Bezuges veränderbares Profil von Sollwerten und/oder Sollwertbereichen bestimmt und danach die Regelung vornimmt.

12. Vorrichtung nach Anspruch 11, **gekennzeichnet durch** eine Stelleinheit (73) zur Einstellung der Steuergröße, welche als eine Drossel, vorzugsweise eine einstellbare Drossel, ausgelegt ist, die Teil des Luftzuführsystems (7) ist und den Luftdruck der durch das Luftzuführsystem (7) zugeführten Luft regelt.

13. Vorrichtung nach Anspruch 11 oder 12, **dadurch gekennzeichnet, dass** zur Ermittlung der physikalischen Stoffeigenschaft die Temperatur der Milch-Luft-Emulsion berücksichtigt wird.

14. Vorrichtung nach einem der vorhergehenden Ansprüche 11 bis 13, **dadurch gekennzeichnet, dass** das Luftzufuhrsystem (7) eine Luftquelle (74) zum Ansaugen von Luft in eine Luftleitung (71) des Luftzuführsystem s (7) umfasst.

15. Vorrichtung nach einem der vorhergehenden Ansprüche 11 bis 14, **dadurch gekennzeichnet, dass** die erste Messeinheit (8) als Bauteil direkt druckseitig zur Milchpumpe (6) angeordnet ist.

16. Vorrichtung nach einem der vorhergehenden Ansprüche 11 bis 15, **dadurch gekennzeichnet, dass** die erste Messeinheit oder eine zweite Messeinheit (11) druckseitig hinter einer Nachbearbeitungsvorrichtung (10) zur Optimierung der Verteilung von Luft in einer Milch-Luft-Emulsion angeordnet ist.

## Claims

1. Method by which milk/air emulsions, particularly milk foams, are produced by a device for producing a milk foam, wherein the device at least comprises:
a) a milk duct (3) flowed through by milk,
b) at least one air feed system (7) for producing a milk/air emulsion from the milk,
c) a processing device (9) for heating a milk/air emulsion at a first temperature T1,
d) at least one first measuring unit (8 or 11) for determining at least one physical substance property of the milk/air emulsion, and
e) a regulating and evaluating unit (75) arranged to set a control variable on the basis of the physical substance property of the milk/air emulsion, wherein the regulating and evaluating unit (75) comprises a data memory in which data sets of target values and/or target value ranges are filed in dependence on the temperature and/or a desired drink with milk content and/or a supplied kind of milk,
wherein the method comprises at least the following steps:
A) determining the physical substance property of the milk/air emulsion by at least the first measuring unit (8 or 11),
B) carrying out a comparison by the regulating and evaluating unit (75) between an actual value and a target value range of this physical substance property, wherein the regulating and evaluating unit (75) uses a data memory in which data sets of target values and/or target value ranges are filed in dependence on the temperature and/or a desired drink with milk content and/or a supplied kind of milk,
C) wherein insofar as the actual value lies outside the target value range a setting of at least one setting variable in the method is undertaken by the regulating and evaluating unit (75) in such a way that the physical substance property is influenced,
**characterised in that**
D) the regulating and evaluating unit (75) during a draw determines a non-constant profile, which is variable during the draw, of target values and/or target value ranges and thereafter undertakes the regulation.

2. Method according to claim 1, **characterised in that** the at least one physical substance property is the electrical conductivity of the milk/air emulsion.

3. Method according to claim 1 or 2, **characterised in that** the setting of the setting variable comprises regulation of the air pressure of the air supplied by the air feed system.

4. Method according to any one of the preceding claims, **characterised in that** the setting of the setting variable comprises regulation of the throughflow of the milk or the milk/air emulsion through the milk duct (3), preferably regulation of the throughflow of the milk or the milk/air emulsion through a mixing chamber in which the milk/air emulsion is formed.

5. Method according to any one of the preceding claims, **characterised in that** the setting of the setting variable comprises setting of the processing device (9), particularly a heating device of the processing device (9).

6. Method according to any one of the preceding claims, **characterised in that** the device comprises the first measuring unit (8) and a second measuring unit (11), wherein the measuring unit (8) is arranged between the air feed system (7) for reducing the milk/air emulsion and the processing device (9) for heating the milk/air emulsion and wherein the second measuring unit (11) is arranged downstream of the processing device (9) in the throughflow direction (R) of the milk or milk/air emulsion, wherein the physical substance property is determined before and after heating of the milk/air emulsion.

7. Method according to any one of the preceding claims, **characterised in that** the device comprises a temperature sensor which is arranged downstream of the processing device (9) in throughflow direction (R) of the milk or milk/air emulsion and which determines the temperature of the milk/air emulsion, wherein the regulating and evaluating unit preferably undertakes a temperature compensation of the determined physical substance property.

8. Method according to claim 7, **characterised in that** the temperature sensor or each one of the temperature sensors is a component of the first and/or second measuring unit.

9. Method according to any one of the preceding claims, **characterised in that** the processing device (9) comprises at least one heating duct (91b or 91c) for heating the milk/air emulsion, in which a heating medium, preferably steam, is conducted, wherein the heating duct (91b or 91c) comprises at least one setting valve (93b or 93c) for regulation of the throughflow of the heating medium in the heating duct (91b or 91c) and wherein the setting valve (93b or 93c) is regulated in dependence on the determined temperature of the temperature sensor and/or in dependence on the determined physical substance property.

10. Method according to any one of the preceding claims, **characterised in that** the dwell time of the milk/air emulsion in the processing device (9) is set in dependence on the determined physical substance property.

11. Device for producing milk/air emulsions, particularly milk foams, preferably in accordance with a method according to any one of the preceding claims, with
a) a milk duct (3) flowed through by milk,
b) at least one air feed system (7) for producing a milk/air emulsion,
c) a processing device (9) for heating a milk/air emulsion at a first temperature T1,
d) at least one first measuring unit (8 or 11) for determining a physical substance property of the milk/air emulsion, and
e) a regulating and evaluating unit (75) arranged to set a control variable on the basis of the physical substance property of the milk/air emulsion, wherein the regulating and evaluating unit (75) comprises a data memory in which data sets of target values and/or target value ranges are filed in dependence on the temperature and/or a desired drink with milk content and/or a supplied kind of milk,
**characterised in that**
f) the regulating and evaluating unit (75) during a draw determines a non-constant profile, which is variable during the draw, of target values and/or target value ranges and thereafter undertakes the regulation.

12. Device according to claim 11, **characterised by** a setting unit (73) for setting the control variable, which unit is designed as a throttle, preferably a settable throttle, which is part of the air feed system (7) and regulates the air pressure of the air supplied by the air feed system (7).

13. Device according to claim 11 or 12, **characterised in that** the temperature of the milk/air emulsion is taken into consideration for determining the physical substance property.

14. Method according to any one of the preceding claims 11 to 13, **characterised in that** the air feed system (7) comprises an air source (74) for sucking air in an air duct (71) of the air feed system (7).

15. Device according to any one of the preceding claims 11 to 14, **characterised in that** the first measuring unit (8) is arranged as a component directly on the pressure side with respect to the milk pump (6).

16. Device according to any one of the preceding claims 11 to 15, **characterised in that** the first measuring unit or a second measuring unit (11) is arranged at the pressure side downstream of a re-processing device (10) for optimising distribution of air in a milk/air emulsion.

## Revendications

1. Procédé à l'aide duquel des émulsions lait-air, en particulier des mousses de lait sont obtenues à l'aide d'un dispositif d'obtention d'une mousse de lait, ce dispositif comprenant au moins :
a) une conduite de lait (3) dans laquelle circule du lait,
b) au moins un système d'alimentation en air (7) permettant d'obtenir une émulsion lait-air à partir du lait,
c) un dispositif de préparation (9) permettant de chauffer une émulsion lait-air à une première température T1,
d) au moins une première unité de mesure (8 ou 11) permettant de déterminer au moins une propriété physique de l'émulsion lait-air, et
e) une unité de régulation et d'évaluation (75) qui est équipée pour permettre de régler une grandeur de commande à partir de la propreté physique de l'émulsion lait-air, l'unité de régulation et d'évaluation (75) comprenant une mémoire de données dans laquelle sont déposés des jeux de données de valeurs de consigne et/ou de plages de valeurs de consigne en fonction de la température et/ou de la boisson renfermant du lait souhaitée et/ou du type de lait fourni,
le procédé comprenant au moins les étapes suivantes consistant à :
A) déterminer la propreté physique de l'émulsion lait-air par au moins la première unité de mesure (8 ou 11),
B) effectuer une comparaison avec l'unité de régulation et d'évaluation (75) entre la valeur réelle et une plage de valeurs de consigne de cette propreté physique, l'unité de régulation et d'évaluation (75) utilisant une mémoire de données dans laquelle sont déposés des jeux de données de valeurs de consigne et/ou de plages de valeur de consigne en fonction de la température et/ou de la boisson renfermant du lait souhaitée et/ou du type de lait fourni.
C) dans la mesure où la valeur réelle est située à l'extérieur de la plage de consigne, effectuer, avec l'unité de régulation et d'évaluation (75) un réglage d'au moins une grandeur de réglage dans le procédé de sorte que la propreté physique soit influencée,
**caractérisé en ce que**
D) l'unité de régulation et d'évaluation (75) détermine, lors d'une référence, un profil non constant et variable pendant la référence de valeurs de consigne et/ou de plages de valeurs de consigne et effectue ensuite la régulation.

2. Procédé conforme à la revendication 1,
**caractérisé en ce que**
la propreté physique est la résistivité électrique de l'émulsion lait-air.

3. Procédé conforme à la revendication 1 ou 2,
**caractérisé en ce que**
le réglage de la grandeur de réglage comprend une régulation de la pression de l'air introduit par l'intermédiaire du système d'alimentation en air.

4. Procédé conforme à l'une des revendications précédentes,
**caractérisé en ce que**
le réglage de la grandeur de réglage comprend un réglage du débit du lait ou de l'émulsion lait-air dans la conduite de lait (3), de préférence une régulation du débit du lait ou de l'émulsion lait-air dans une chambre de mélange dans laquelle l'émulsion lait-air est formée.

5. Procédé conforme à l'une des revendications précédentes,
**caractérisé en ce que**
le réglage de la grandeur de réglage comprend un réglage du dispositif de traitement (9), en particulier d'un dispositif de chauffage du dispositif de traitement (9).

6. Procédé conforme à l'une des revendications précédentes,
**caractérisé en ce que**
le dispositif comporte la première unité de mesure (8) et une seconde unité de mesure (11), l'unité de mesure (8) étant installée entre le système d'alimentation en air (7) permettant d'obtenir l'émulsion lait-air et le dispositif de traitement (9) permettant de chauffer l'émulsion lait-air, et la seconde unité de mesure (11) étant installée à l'arrière du dispositif de traitement (9) dans la direction de circulation R du lait ou de l'émulsion lait-air, la propreté physique étant déterminée avant et après le chauffage de l'émulsion lait-air.

7. Procédé conforme à l'une des revendications précédentes,
**caractérisé en ce que**
le dispositif comporte un capteur de température qui est installé après le dispositif de traitement (9) dans la direction de circulation R du lait ou de l'émulsion lait-air et qui détermine la température de l'émulsion lait-air, l'unité de traitement et d'évaluation effectuant de préférence une compensation de la température de la propreté physique déterminée.

8. Procédé conforme à la revendication 7,
**caractérisé en ce que**
le capteur de température ou chaque capteur de température est un composant de la première et/ou de la seconde unité de mesure.

9. Procédé conforme à l'une des revendications précédentes,
**caractérisé en ce que**
le dispositif de traitement (9) comporte au moins une conduite de chauffage (91b ou 91c) permettant de chauffer l'émulsion lait-air, dans laquelle circule un fluide de chauffage, de préférence de la vapeur et la conduite de chauffage (91b ou 91c) comporte au moins une soupape de réglage (93b ou 93c) permettant de réguler le débit du fluide de chauffage dans la conduite de chauffage (91b ou 91c), la soupape de réglage (93b ou 93c) étant réglée en fonction de la température détectée par le capteur de température et/ou en fonction de la propreté physique détectée.

10. Procédé conforme à l'une des revendications précédentes,
**caractérisé en ce que**
le temps de séjour de l'émulsion lait-air dans le dispositif de traitement (9) est réglé en fonction de la propreté physique déterminée.

11. Dispositif permettant d'obtenir des émulsions lait-air en particulier des mousses de lait de préférence par la mise en œuvre d'un procédé conforme à l'une des revendications précédentes comprenant :
a) une conduite de lait (3) dans laquelle circule du lait,
b) au moins un système d'alimentation en air (7) permettant d'obtenir une émulsion lait-air,
c) un dispositif de traitement (9) permettant de chauffer l'émulsion lait-air à une première température T1,
d) au moins une première unité de mesure (8 ou 11) permettant de déterminer une propreté physique de l'émulsion lait-air, et
e) une unité de régulation et d'évaluation (75) qui est équipée pour permettre de régler une grandeur de réglage à partir de la propreté physique de l'émulsion lait-air, l'unité de régulation et d'évaluation (75) comprenant une mémoire de données dans laquelle sont déposés des jeux de données de valeurs de consigne et/ou de plages de valeurs de consigne en fonction de la température et/ou de la boisson renfermant du lait souhaitée et/ou du type de lait fourni,
**caractérisé en ce que**
f) l'unité de réglage et d'évaluation (75) détermine pendant une référence un profil non constant et variable pendant la référence de valeurs de mesure et/ou de plages de valeurs de mesure et effectue ensuite la régulation.

12. Dispositif conforme à la revendication 11,
**caractérisé par**
une unité de réglage (73) qui est réalisée pour permettre de régler la grandeur de commande, qui est réalisée sous la forme d'un étranglement, de préférence d'un étranglement réglable qui est une partie du système d'alimentation en air (7) et règle la pression de l'air qui est fourni par le système d'alimentation en air (7).

13. Dispositif conforme à la revendication 11 ou 12,
**caractérisé en ce que**
pour permettre de déterminer la propreté physique on prend en considération la température de l'émulsion lait-air.

14. Dispositif conforme à l'une des revendications précédentes 11 à 13,
**caractérisé en ce que**
le système d'alimentation en air (7) comporte une source d'air (74) permettant d'aspirer de l'air dans une conduite d'air (71) du système d'alimentation en air (7).

15. Dispositif conforme à l'une des revendications précédentes 11 à 14,
**caractérisé en ce que**
la première unité de mesure (8) est agencée en tant que composant situé directement côté pression de la pompe à lait (6).

16. Dispositif conforme à l'une des revendications précédentes 11 à 15,
**caractérisé en ce que**
la première unité de mesure ou une seconde unité de mesure (11) est installée côté pression à l'arrière d'un dispositif de post-traitement (10) permettant d'optimiser la répartition de l'air dans l'émulsion lait-air.
